# EUROPÄISCHE PATENTANMELDUNG

(11) **EP 2 187 722 A2**
(43) Veröffentlichungstag der Anmeldung: **19.05.2010**
(21) Anmeldenummer: 09012548.5
(22) Anmeldetag: 05.10.2009
(51) Int. Cl.: H05K 7/14

(54) **Ein-/ Ausgabemodul für ein Automatisierungsgerät**

(30) Priorität: 18.11.2008 DE 102008058090
(71) Anmelder: ABB AG, 68309 Mannheim (DE)
(72) Erfinder: Gaub, Gernot, Dipl.-Ing., 68766 Hockenheim (DE); Wilmers, Andreas, Dipl.-Phys., 69123 Heidelberg (DE)

(57) **Zusammenfassung**

Die Erfindung betrifft ein Ein-/ Ausgabemodul für ein Automatisierungsgerät mit einem teilbaren Gehäuse (2), (3) mit einer Elektronikbaugruppe für die Ein/Ausgabefunktion des Ein-/Ausgabemoduls, mit Anschlusselementen (10), (20) und mit jeweils den Anschlusselementen (10), (20) zugeordneten an der Gerätefrontseite (4) angeordneten Lichtleitern (51) zur Zustandssignalisierung der Ein-/Ausgabekanäle des Ein-/Ausgabemoduls. Die Elektronikbaugruppe für die Ein/Ausgabefunktion des Ein-/Ausgabemoduls und die Anschlusselemente (10), (20) zum Anschluss von Signalleitungen und Prozessspannungen ist auf einer ersten im Gehäuse (2), (3) des Ein/Ausgabemoduls befindlichen ersten Leiterplatte (PCB1) angeordnet, wobei die Anschlusselemente (10), (20) von der Gerätefrontseite (4) des Ein-/Ausgabemoduls zugänglich sind.

## Beschreibung

Die Erfindung betrifft ein Ein-/ Ausgabemodul für ein flexibles erweiterbares Automatisierungsgerät gemäß dem Oberbegriff des Anspruches 1.

Marktübliche oder in Patentdokumenten beschriebene erweiterbare Automatisierungsgeräte, auch als speicherprogrammierbare Steuerungen bekannt, sind an unterschiedlichste Automatisierungsaufgaben anpassbar und werden insbesondere im Bereich der industriellen Automatisierungstechnik und im Bereich der Schalt- und Steuerungstechnik eingesetzt.

Diese Automatisierungssysteme sind üblicherweise modular aus einer Zentralbaugruppe, Kommunikationskopplern und Erweiterungsmodulen, beispielsweise Ein-/ Ausgabemodulen aufgebaut.

Die Ein-/ Ausgabemodule, die über eine als Ein/Ausgabebus ausgeführte interne Busverbindung elektrisch mit einer die Zentraleinheit (CPU) aufweisenden Zentralbaugruppe verbunden sind, umfassen gemäß dem bekannten Stand der Technik ein aus zwei Teilen bestehendes teilbares Gehäuse mit wenigstens einer Frontabdeckung, mit Anschlussklemmen sowie mit Anzeigemitteln zur Anzeige des aktuellen Betriebszustandes eines der jeweiligen Anschlußklemme zugeordneten Schalt- und/oder Steuerungsmoduls, auch als Zustandssignalisierung der Ein-/Ausgabekanäle bezeichnet.

Gemäß dem Stand der Technik sind Ein-/ Ausgabemodule bekannt, in dessen Gehäuseunterteil mehrere Leiterplatten in ein Gehäuseunterteil eingeschoben sind. Auf den Leiterplatten der Ein-/ Ausgabemodule sind Elektronikbaugruppen für Ein/ Ausgabefunktionen, Anschlussklemmen sowie Anzeigemittel, beispielsweise zur Anzeige des aktuellen Betriebszustandes eines der jeweiligen Anschlussklemme zugeordneten Schalt- und/oder Steuerungsmoduls angeordnet. Die Anschlussklemmen sind entsprechend ihrer Funktion mit den Leiterplatten elektrisch verbunden und am rückwärtigen Teil des Gehäuseunterteils aus dem Gehäuse herausgeführt. Somit sind die Anschlussklemmen von der Fronseite des Moduls, welche die Anzeigemittel aufweist, nicht zugänglich.

Bedingt durch die mechanische Ausführung, insbesondere die Verwendung mehrerer Leiterplatten für die Realisierung der Funktionen des Ein-/Ausgabemoduls, benötigt das vorab beschriebene Ein-/Ausgabemodul einen umfangreichen Platzbedarf und ist in der Herstellung aufwendig und kostenintensiv.

Der Erfindung liegt demgemäß die Aufgabe zugrunde, ein kostengünstiges und einfach aufgebautes Ein-/ Ausgabemodul für ein Automatisierungsgerät zu schaffen, bei dem die vorgenannten Nachteile überwunden werden und welches gegenüber den bekannten Ein-/ Ausgabemodulen insbesondere eine kompaktere Bauweise aufweist und kostengünstig herstellbar ist. Das Ein-/ Ausgabemodul kann sowohl ein Eingabemodul, ein Ausgabemodul oder auch ein Ein- und Ausgabemodul sein.

Diese Aufgabe wird erfindungsgemäß durch ein Ein-/Ausgabemodul für ein Automatisierungsgerät mit den in Anspruch 1 angegebenen Merkmalen gelöst. Vorteilhafte Ausgestaltungen und Verbesserungen des erfindungsgemäßen Ein-/Ausgabemodul sind in weiteren Ansprüchen und in der Beschreibung angegeben.

Erfindungsgemäß ist vorgesehen, die Anzahl der im Ein-/Ausgabemodul angeordneten als Leiterplatten oder Platinen ausgeführten Träger zu reduzieren, indem die Elektronikbaugruppe für die Ein/Ausgabefunktion des Ein-/Ausgabemoduls auf einer ersten im Gehäuse des Ein/Ausgabemoduls befindlichen Leiterplatte angeordnet ist. Weiterhin ist eine zweite Leiterplatte zum Durchschleifen der Signale eines Ein-/Ausgabebusses vorgesehen.

Weiterhin ist vorgesehen, auch die Anschlusselemente, die beispielsweise den Anschluss von Signalleitungen und Prozessspannungen externer Feldgeräte ermöglichen, und den Anschluss für den Ein/Ausgabebus auf der ersten Leiterplatte zu integrieren. Somit ist durch die Anordnung, der vorzugsweise als steckbare Klemmen ausgeführten Anschlusselemente für Prozeßstecker bzw. Prozeßsignale auf der ersten Leiterplatte, ein kostengünstiges Ein-/Ausgabemodul herstellbar.

Die Anschlusselemente sind vorzugsweise als Schraubklemmen, Schneidklemmen oder Federzug- bzw. Federkraftklemmen ausgeführt und von der Frontseite des Ein-/Ausgabegerätes zugänglich.

Entsprechend einer vorteilhaften Ausführungsform des erfindungsgemäßen Ein-/ Ausgabemoduls sind für die Zustandssignalisierung der Ein/Ausgabekanäle auf der ersten Leiterplatte Lichtleiter vorgesehen, die dafür vorgesehen sind, das Licht der Anzeigemittel zu bündeln und kontaktlos auf die Frontseite des Ein-/Ausgabemoduls zu übertragen.

Anhand der in den folgenden Figuren dargestellten Ausführungsformen sollen die Erfindung sowie vorteilhafte Ausgestaltungen, Verbesserungen und weitere Vorteile der Erfindung näher erläutert und beschrieben werden.

Es zeigen:
- **Fig.** 1: ein beispielhaftes Ein- und Ausgabemodul,
- **Fig.** 2: eine beispielhafte Ausführung der Leiterplatten des Ein-/Ausgabemoduls mit der Anordnung der Leiterplatten und der Anschluss- und Anzeigemittel des Ein- und Ausgabemoduls,
- **Fig.** 3: eine beispielhafte Ausführung eines Anzeigemittels des Ein-/Ausgabe-Moduls,
- **Fig**. 4: eine beispielhafte Zapfen-Loch-Verbindung von aufeinandergestapelten Gleichteilen,
- **Fig**. 5: eine beispielhafte Ausgestaltung eines Gleichteiles des Lichtleiters,
- **Fig**. 6: eine beispielhafte Ausführung des Zubehörteils, dass als Abstandshalter für die Schraubbefestigung des Ein- und Ausgabemoduls verwendet wird, und
- **Fig**. 7: die Anordnung der Leiterplatten mit den Steckern für das Durchschleifen des Ein/Ausgabebus zu weiteren Modulen des Automatisierungsgerätes.

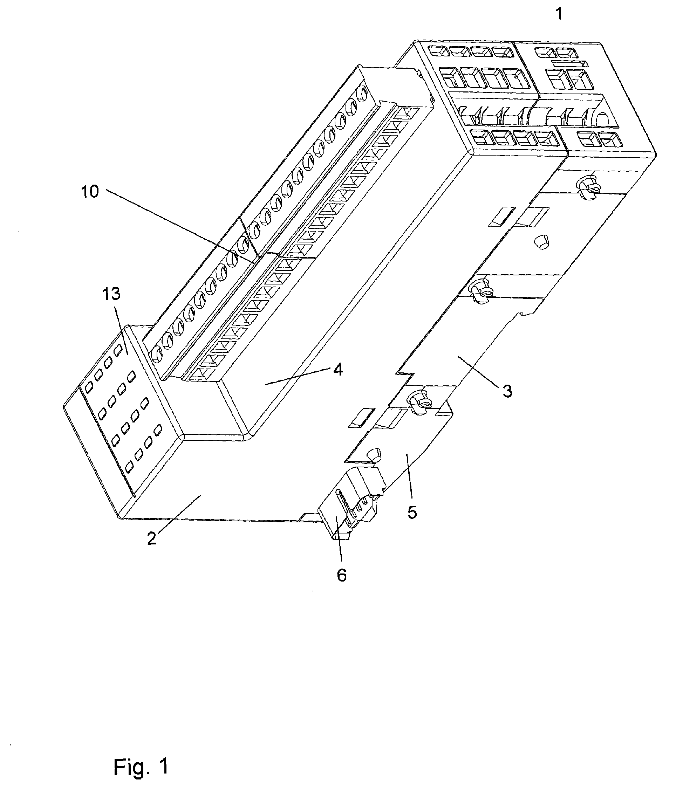

**Fig.** 1 zeigt eine beispielhafte Ausführung eines Ein-/Ausgabemoduls 1 für ein flexibles erweiterbares Automatisierungsgerät mit einem zweiteiligem Gehäuse 2 bestehend aus einem Gehäuseunterteil 3 und einem Gehäuseoberteil 2. Auf dem Gehäuseunterteil 3 sind eine erste Leiterplatte und eine zweite Leiterplatte eingebaut. Die erste Leiterplatte weist eine Elektronikbaugruppe für die Ein/Ausgabefunktion des Ein-/Ausgabemoduls 1 auf und die zweite Leiterplatte ist zum Durchschleifen der Signale eines Ein-/Ausgabebusses vorgesehen.

Von der Gehäusefrontseite 4 sind die als steckbare Klemmen ausgeführte Anschlusselemente 10 zum Anschluss von Signalleitungen und Prozessspannungen zugänglich.

An der Gerätefrontseite sind auch Anzeigemittel 13 angeordnet, die zur Anzeige des aktuellen Betriebszustandes eines der jeweiligen Anschlussklemme 10 in **Fig**. 1 nicht dargestelltem zugeordneten Schalt- und/oder Steuerungsmoduls vorgesehen sind. Die Anzeigemittel 13 sind als Lichtleiter ausgeführt und dafür vorgesehen das Licht an einer festgelegten Stelle zu bündeln und kontaktlos auf die Frontseite 4 des Ein-/Ausgabemoduls 1 zu übertragen. Durch das mittels in den verwendeten Lichtleitern 51 gebündelte Licht wird somit in vorteilhafter Weise erreicht, dass das Licht nur an einer Stelle auf der Frontseite 4 des Ein-/Ausgabemoduls 1 ausgegeben wird.

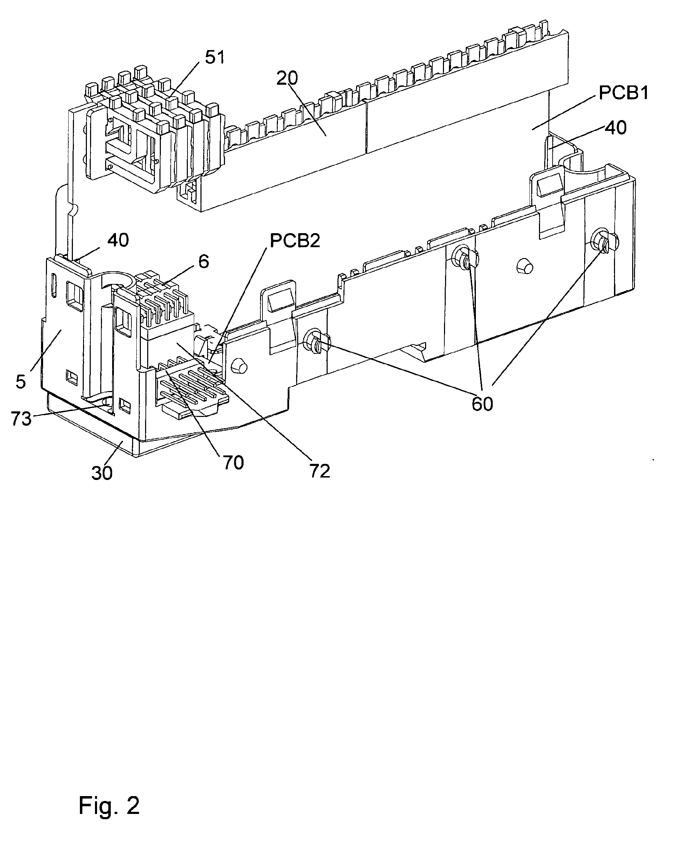

Die elektrische Verbindung der Anschlussklemmen 10 mit der Elektronikbaugruppe für die Ein/Ausgabefunktion wird über einen in Fig. 2 dargestellten Stecker 20 realisiert.

Die steckbare Anschlussklemme 10 kann aus einem oder mehreren mehrpoligen Klemmen durch Anreihung entstehen. Je nach Anzahl der Ein/Ausgabefunktionen des Ein-/Ausgabemoduls 1 kann die Polzahl der Klemme 10 und des entsprechenden Steckers 20 unterschiedlich sein.

Erfindungsgemäß umfasst die erste Leiterplatte neben der Elektronikbaugruppe für die Ein/Ausgabefunktion des Ein-/Ausgabemoduls 1 auch den Stecker 20, der so auf der ersten Leiterplatte angeordnet ist, dass er, wie auch die Anzeigemittel 13, von der Frontseite 4 des Gehäuses zugänglich ist. Weiterhin ist auf der ersten Leiterplatte ein weiteres Anschlusselement 6, welches vorzugsweise als standardisierter Stecker ausgeführt ist, für die Übertragung der Signale des Ein/ Ausgabebus auf der zweiten Leiterplatte vorgesehen.

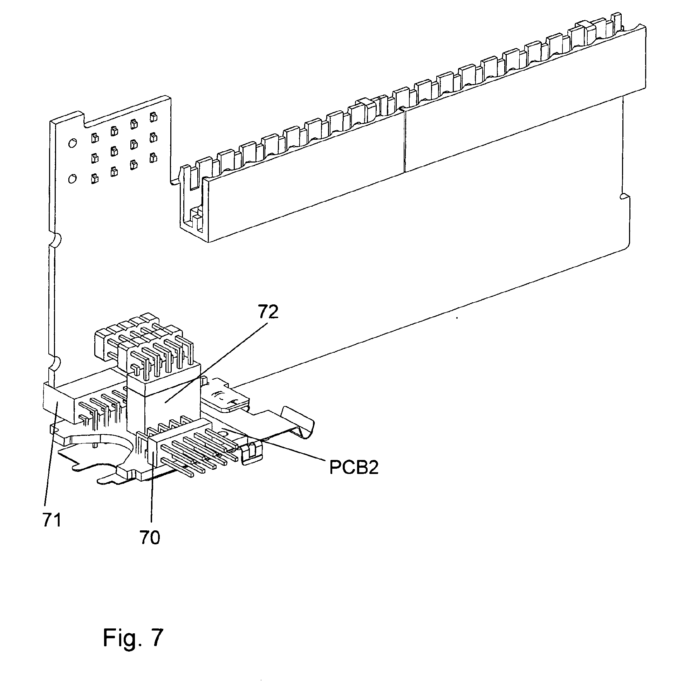

Über einen zweiten in **Fig. 7** dargestellten Stecker 70 und den Ein/ Ausgabebus sind weitere Module und die Zentraleinheit des Automatisierungssystems an das Ein-/Ausgabemoduls 1 anschließbar. Über den zweiten Stecker 70 und einen in **Fig**. 7 dargestellten weiteren Stecker 71 sind die Signale des Ein/Ausgabebus von Modul zu Modul durchschleifbar.

In **Fig**. 2 ist eine beispielhafte Ausführung der ersten Leiterplatte PCB1 des Ein-/Ausgabemoduls 1 für die Elektronikbaugruppe gezeigt, die in Führungen 40 eingeschoben ist. Die Führungen 40 für die erste Leiterplatte PCB1 sind vorzugsweise auf dem innen liegenden Bereich des Gehäuseunterteils 3 und im unteren Bereich der Gehäuseseiten 5 angeordnet.

Auf der dem Gehäuseunterteil 3 abgewandten Seite der ersten Leiterplatte PCB1 sind die Stecker 20 angeordnet, wodurch in vorteilhafter Weise erreicht wird, dass an die Klemmen 10 von der Frontseite 4 des Gehäuses Prozessstecker anschließbar sind. Die Stecker 20 sich können, wie in **Fig**. 2 beispielhaft gezeigt, als mehrteilige Elemente ausgeführt sein, wobei die Anzahl der verwendeten Stecker 20 flexibel gestaltet ist. Die Anschlussklemmen 10 sind für einen Anschluss von Signalen und Prozessspannungen externer Feldgeräte, wie beispielsweise Sensoren und Aktoren, vorzugsweise in Federzug- oder Schraubanschlusstechnik ausgeführt.

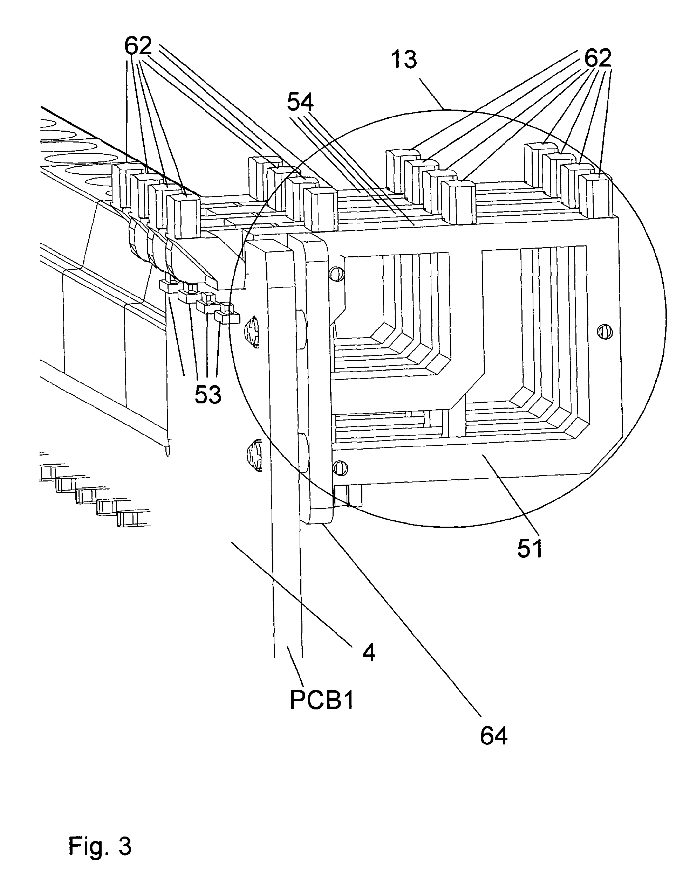

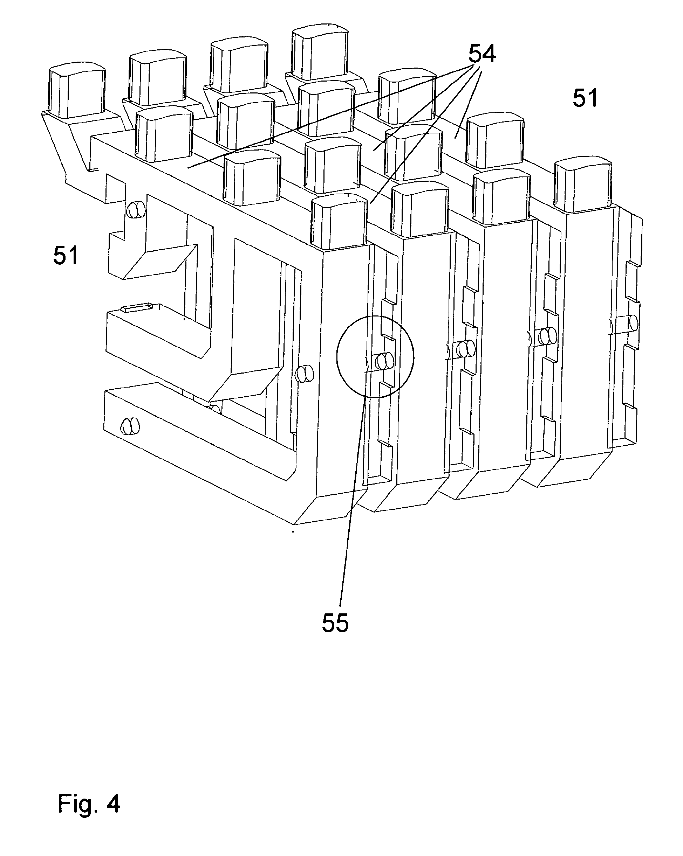

Weiterhin sind auf der dem Gehäuseunterteil 3 abgewandten Seite der ersten Leiterplatte PCB1 Lichtleiter 51 aufgesteckt, deren detaillierte Darstellung beispielhaft in **Fig.** 3 gezeigt.

Das weitere Anschlusselement 6 für den Anschluss des Ein/ Ausgabebus ist so auf der ersten Leiterplatte PCB1 angeordnet, dass es in den auf der zweiten Leiterplatte PCB2 angeordneten weiteren Stecker 72 eingesteckt ist, wodurch die Signale des Ein/Ausgabebus von der ersten Leiterplatte PCB1 auf die zweite Leiterplatte PCB2 übertragbar sind.

Im unterem seitlichen Bereich des Gehäuses sind weiterhin Anschlussmittel 60, vorzugsweise Zentrierstifte oder Rastpilze, zum Anschluss weiterer Module an das Ein-/Ausgabemodul 1 vorgesehen.

Ist das Automatisierungsgerät mit dem Ein-/Ausgabemodul 1 und eventuell erforderlichen Erweiterungsmodulen für eine Wandmontage vorgesehen, wird ein Zubehörteil 30 eingesetzt. Das Zubehörteil 30 wirkt als Abstandhalter und verhindert eine Verformung des Gehäuses bei Schraubbefestigung des Moduls durch eine Bohrung 73.

**Fig**. 3 zeigt eine beispielhafte Ausführung eines Anzeigemittels 13 mit einer detaillierten Darstellung des Lichtleiters 51 des Ein-/Ausgabemoduls 1, welches auf der ersten Leiterplatte PCB1 angeordnet ist. Das Anzeigemittel 13 wird durch den Lichtleiter 51 gebildet, der das von optischen Anzeigeelementen 53, vorzugsweise Leuchtdioden, erzeugte Licht bündelt und kontaktlos an Austrittsöffnungen 62 überträgt. Somit wird das vom Lichtleiter 51 gebündelte Licht von den Anzeigeelementen 53 an jeweils zugeordnete Lichtaustrittsflächen auf der Frontseite 4 des Ein-/Ausgabemoduls 1 übertragen.

Eine Blende 64 hält den aus vier Gleichteilen 54 aufgebauten ersten Lichtleiter 51 zusammen und verhindert ein Übersprechen zwischen den einzelnen Strängen des ersten Lichtleiters 51.

Der Lichtleiter 51 kann aus mehreren hintereinander angeordneten Lichtleitergleichteilen 54 aufgebaut und so ausgestaltet sein, dass zu seiner Herstellung einfache und kostengünstige Spritzgusswerkzeuge verwendbar sind. Die konstruktive Ausgestaltung der Gleichteile 54 des Lichtleiters 51 ist der **Fig**. 5 zu entnehmen.

Die Anordnung der Gleichteile 54 wird, beispielsweise durch Aufeinanderstapeln der Gleichteile 54 und eine Verbindung der Gleichteile 54, vorzugsweise über eine Zapfen-Loch-Verbindung, erreicht. Eine beispielhafte Zapfen-Loch-Verbindung 55 von aufeinandergestapelten Gleichteilen 54 zeigt **Fig**. 4.

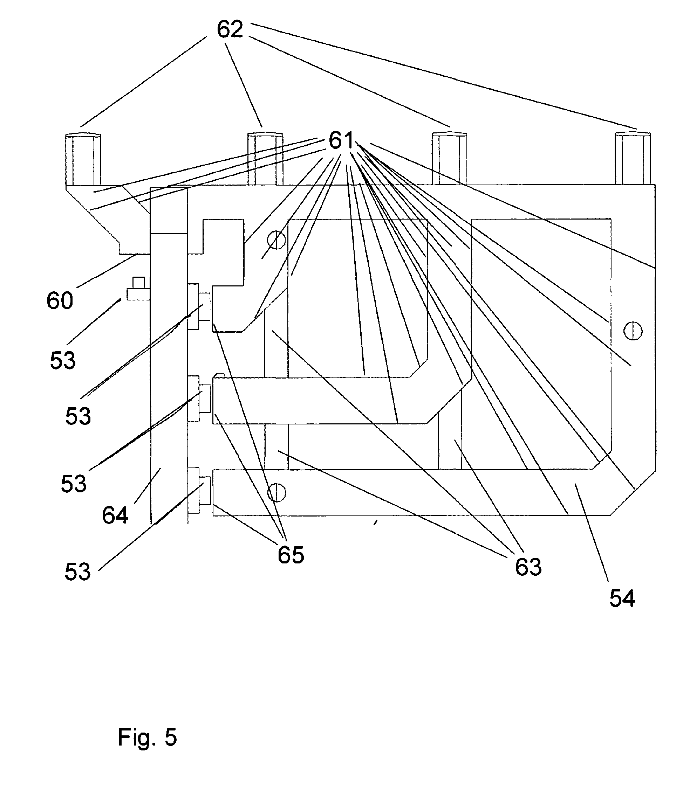

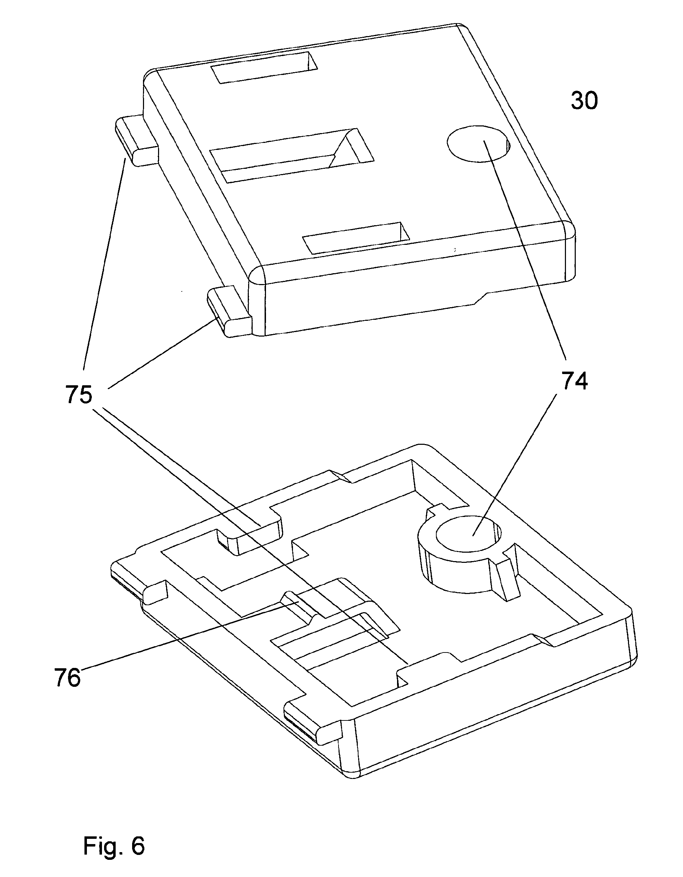

In **Fig.** 5 ist eine beispielhafte Ansicht eines Gleichteiles 54 des Lichtleiters 51 dargestellt und verdeutlicht die Ausgestaltung des Gleichteiles 54. Das Gleichteil 54 besteht aus vier einzelnen Lichtleitersträngen. Das Gleichteil 54 ist durch Stege 63 ausgesteift.

Das das von den optischen Anzeigeelementen 53 erzeugte Licht tritt über Eintrittsflächen 65 des Gleichteils 54 ein, wird dann über Totalreflexion an den Flächen 61 reflektiert und tritt an den Austrittsöffnungen bzw. in den Flächen 62 aus.

**Fig**. 6 zeigt eine beispielhafte Ausführung des Zubehörteils 30. Das Zubehörteil 30 wirkt als Abstandhalter und verhindert eine Verformung des Gehäuses bei Schraubbefesting des Ein-/Ausgabemoduls 1 durch die Bohrungen 73 und 74. Das Zubehörteil 30 wird über Zapfen 75 an dem Gehäuseunterteil 3 ausgerichtet, wobei eine Rastnase 76 ein Herausfallen des Zubehörteiles 30 verhindert.

**Fig**. 7 zeigt die Anordnung der Leiterplatten PCB1, PCB 2 mit den Steckern 70, 71 für das Durchschleifen des Ein/Ausgabebus zu weiteren Modulen des Automatisierungsgerätes.

Über den zweiten Stecker 70 und den Ein/ Ausgabebus sind weitere Module und die Zentraleinheit des Automatisierungssystems an das Ein-/Ausgabemoduls 1 anschließbar. Über den zweiten Stecker 70 und den weiteren Stecker 71 sind die Signale des Ein/Ausgabebus somit von Modul zu Modul durchschleifbar.

### Bezugszeichenliste

- 1: Ein-/Ausgabemodul
- 2: Gehäuseoberteil
- 3: Gehäuseunterteil
- 4: Gehäusefrontseite
- 5: Gehäuseseite
- 6: weiteres Anschlusselement, Anschluss für Ein-/Ausgabebus
- 10: Anschlusselement
- 13: Anzeigemittel
- 20: Stecker
- 30: Zubehörteil
- 51: Lichtleiter
- 53: Anzeigeelement
- 54: Gleichteil des Lichtleiters
- 55: Zapfen-Loch-Verbindung
- 56: Träger
- 57: Verbindungselement
- 60: Anschlussmittel
- 61: Reflexionsfläche
- 62: Austrittsöffnungen, Austrittsfläche
- 63: Steg
- 64: Blende
- 65: Eintrittsöffnung
- 70: zweiter Stecker
- 71: weiterer Stecker
- 72: weiterer Stecker
- 73,74: Bohrung
- 75: Zapfen
- 76: Rastnase
- PCB1: erster Träger, Platine, Leiterplatte
- PCB2: zweiter Träger, Platine, Leiterplatte

## Patentansprüche

1. Ein-/ Ausgabemodul für ein Automatisierungsgerät mit einem teilbaren Gehäuse (2), (3) mit einer Elektronikbaugruppe für die Ein/Ausgabefunktion des Ein-/Ausgabemoduls, mit Anschlusselementen (10), (20) und mit jeweils den Anschlusselementen (10), (20) zugeordneten an der Gerätefrontseite (4) angeordneten Lichtleitern (51) zur Zustandssignalisierung der Ein-/Ausgabekanäle des Ein-/Ausgabemoduls **dadurch gekennzeichnet, dass** die Elektronikbaugruppe für die Ein/Ausgabefunktion des Ein-/Ausgabemoduls und die Anschlusselemente (10), (20) zum Anschluss von Signalleitungen und Prozessspannungen auf einer ersten im Gehäuse (2), (3) des Ein/Ausgabemoduls befindlichen Leiterplatte (PCB1) angeordnet ist, wobei die Anschlusselemente (10), (20) von der Gerätefrontseite (4) des Ein-/Ausgabemoduls zugänglich sind.

2. Ein-/Ausgabemodul nach Anspruch 1, **dadurch gekennzeichnet, dass** die elektrische Verbindung der Anschlusselemente (20) über Signalleitungen und Prozessspannungsleitungen mit daran angeschlossenen Schalt- und/oder Steuerungsmodulen über einem mit den Anschlusselementen (20) verbundenen Klemmenblock (10) realisiert ist.

3. Ein-/Ausgabemodul nach einen der vorherigen Ansprüche, **dadurch gekennzeichnet, dass** die erste Leiterplatte (PCB1) ein weiteres Anschlusselement (6) zum Anschluss eines Ein-/Ausgabebus für weitere Module des Automatisierungsgerätes aufweist.

4. Ein-/Ausgabemodul nach einen der vorherigen Ansprüche, **dadurch gekennzeichnet, dass** das weitere Anschlusselement (6) für den Anschluss des Ein-/ Ausgabebus so auf der ersten Leiterplatte (PCB1) angeordnet ist, dass es mit einem Anschlusselement (72) auf einer zweiten Leiterplatte (PCB2) verbunden ist und Anschlussstecker (70), (71) für den Ein/Ausgabebus aus dem unterem seitlichen Bereich des Gehäuses (2), (3) herausragen.

5. Ein-/Ausgabemodul nach einen der vorherigen Ansprüche, **dadurch gekennzeichnet, dass** die erste Leiterplatte (PCB1) in Führungen (40) eingeschoben ist, wobei die Führungen (40) für die erste Leiterplatte (PCB1) im innen liegendem Bereich des Gehäuseunterteils (3), vorzugsweise im unteren Bereich der Gehäuseseiten (5) angeordnet ist.

6. Ein-/Ausgabemodul nach einen der vorherigen Ansprüche, **dadurch gekennzeichnet, dass** im unterem seitlichen Bereich des Gehäuses (2), (3) Anschlussmittel 60, vorzugsweise Zentrierstifte oder Rastpilze, zum Anschluss weiterer Module an das Ein-/Ausgabemodul vorgesehen sind.

7. Ein-/Ausgabemodul nach einem der vorherigen Ansprüche, **dadurch gekennzeichnet, dass** auf der ersten Leiterplatte (PCB1) als Lichtleiter (51) ausgeführte Anzeigemittel (13) angeordnet sind, die das von optischen Anzeigeelementen (53) erzeugte Licht bündeln und kontaktlos auf die Frontseite (4) des ein- Ausgabemoduls zu übertragen.

8. Ein-/Ausgabemodul nach einem der vorherigen Ansprüche, **dadurch gekennzeichnet, dass** der Lichtleiter (51) aus Gleichteilen (54) ausgeführt ist.

9. Ein-/Ausgabemodul nach einem der vorherigen Ansprüche, **dadurch gekennzeichnet, dass** das teilbare Gehäuse aus zwei Teilen (2), (3) aufgebaut ist.
